# EUROPEAN PATENT APPLICATION

(11) **EP 4 567 814 A1**
(43) Date of publication of application: **11.06.2025**
(21) Application number: 24207194.2
(22) Date of filing: 17.10.2024
(51) Int. Cl.: G11C 29/56

(54) **INSERT MODULE FOR TEST HANDER AND TEST TRAY COMPRISING THE SAME**

(30) Priority: 06.12.2023 KR 20230175381; 02.08.2024 KR 20240103301
(71) Applicant: ATECO Inc., Gunpo-si Gyeonggi-do 15880 (KR)
(72) Inventor: LEE, Taek Seon, 18441 Hwaseong-si (KR); KIM, Ho Nam, 13375 Seongnam-si (KR); MOON, Sung Chul, 15821 Gunpo-si (KR); BAE, Han Su, 15012 Siheung-si (KR)
(74) Representative: Habermann, Hruschka & Schnabel

(57) **Abstract**

Disclosed is an insert module for test tray, including: a pitch adjuster configured to seat the electronic device thereon, and including a first side electrically connected to connection pins of the electronic device, and a second side provided with electrical contact means at a second pitch wider than a first pitch of the connection pins; and a holder configured to hold the seated electronic device.

According to the disclosure, the insert module for test tray and the test tray including the same are capable of the accurate contact corresponding to the fine pitch of the electronic device, and maintain the precise contact during the test, thereby improving the accuracy of the test.

## Description

### BACKGROUND OF THE INVENTION

### Field of the Invention

The disclosure relates to an insert module for test tray and a test tray including the same, and more particularly to an insert module capable of testing an electronic device having a fine pitch, and a test tray including the same.

### Description of the Related Art

As one of major modern technologies, A high bandwidth memory (HBM) has originated from increase in a memory bandwidth mostly demanded for high-performance applications of a computer and a graphic processing unit.

The existing technology of graphics double data rate (GDDR) memories has been widely used in high-performance graphic cards and systems, but has reached its limitation due to the demand for the increase in the bandwidth. Therefore, memory manufacturers have demanded new technologies for providing a higher bandwidth and processing data more efficiently.

To meet such demands, an innovative design of forming a memory chip stack has been adopted in the HBM. The HBM uses memory chips vertically stacked to achieve a high bandwidth and provide advantages of reducing power consumption while occupying less space. Due to these characteristics, the HBM has attracted attention as the memory bandwidth and the power efficiency become increasingly important in high-performance computing and graphic-processing systems.

The HBM needs to undergo a test in its die state before packaging. HBM dies have many more contact portions than the existing memory, and many contact portions are provided at fine pitches within a limited area. However, a conventional test handler has a problem in that fine-pitch contact for testing the HBM is difficult.

### Documents of Related Art

(Patent Document 1) Korean Patent Publication No. 10-2021-0148743

### SUMMARY OF THE INVENTION

An aspect of the disclosure is to provide an insert module for test tray, by which a conventional semiconductor having fine pitch can be quickly and accurately tested, and a test tray including the same.

According to the disclosure, there is provided an insert module for test tray, including: a pitch adjuster configured to seat the electronic device thereon, and including a first side electrically connected to connection pins of the electronic device, and a second side provided with electrical contact means at a second pitch wider than a first pitch of the connection pins; and a holder configured to hold the seated electronic device.

Here, the electronic device may be a high bandwidth memory.

Meanwhile, the pitch adjuster may be configured to electrically connect with the connection pins at a plurality of points.

In addition, the first pitch may be 0.5 mm or less.

Meanwhile, the second pitch may be 2 to 10 times the first pitch.

Further, the pitch adjuster may comprise: a plurality of first pins arranged at the first pitch; and a plurality of second pins arranged at the second pitch.

Meanwhile, the first pin may have a width of 0.2 mm or less.

Further, the second pin may have a diameter of 0.3 mm to 3mm.

Meanwhile, the pitch adjuster may further comprise a pitch adjusting block provided between the first pin and the second pin, and the pitch adjusting block may comprise a plurality of connectors to electrically connect the first pins and the second pins, respectively.

Meanwhile, at least some of the conductors may be provided at an angle.

Meanwhile, the holder may comprise: an upper block formed with a hole in a center portion thereof to pass the electronic device therethrough; and a lower block provided with the pitch adjuster in a center portion thereof.

Meanwhile, the holder may further comprises a latching link having a first side rotatably connected to the upper block and a second side rotatably connected to the lower block.

Meanwhile, the latching link may be configured to pivot upward when the upper block moves close to the lower block.

Further, the latching link may further comprise a latching unit, and the latching unit may have a first side rotatably connected to the upper block, and a second side including a pushing block configured to press an upper portion of the electronic device.

Meanwhile, the insert module may further comprise at least one elastic unit provided between the upper block and the lower block, and providing a restoring force to return the upper block to an original position.

In addition, the pushing block may further comprise a thermal pad provided at an end portion thereof to be in contact with the electronic device.

According to an embodiment of the disclosure, there is provided a test tray for an electronic device, including: a board including a lower portion configured to electrically connect with a tester; an insert module configured to hold the electronic device loaded therein during a test; and a base frame configured to arrange the plurality of insert modules thereon, the insert module including: a pitch adjuster configured to seat the electronic device thereon, and including a first side electrically connected to connection pins of the electronic device, and a second side provided with electrical contact means at a second pitch wider than a first pitch of the connection pins; and a holder configured to hold the seated electronic device.

Here, a plurality of sub-trays may be arranged on the board.

Meanwhile, the sub-tray may be detachably configured in the board.

### BRIEF DESCRIPTION OF THE DRAWINGS

FIG. 1 is a perspective view of a test tray for an electronic device according to an embodiment of the disclosure.
FIG. 2 is an exploded perspective view of a sub-tray according to an embodiment of the disclosure.
FIG. 3 is a perspective view of an insert module for test tray according to another embodiment of the disclosure.
FIG. 4 is an exploded perspective view of an insert module for test tray according to another embodiment of the disclosure.
FIG. 5 is a cross-sectional view of a pitch adjuster in an insert module for test tray according to another embodiment of the disclosure.
FIG. 6A is an enlarged view of 'I' in FIG. 5.
FIG. 6B is an enlarged view of 'II' in FIG. 5.
FIG. 7 illustrates pitch between first pins and pitch between second pins in an insert module for test tray according to another embodiment of the disclosure.
FIGS. 8A, 8B, 8C, 8D, 8E, 8F, 8G and 8H illustrate the use states of an insert module for test tray according to an embodiment of the disclosure.

### DETAILED DESCRIPTION OF THE INVENTION

Below, an insert module for test tray according to an embodiment of the disclosure and a test tray including the same will be described in detail with reference to the accompanying drawings. In the following description, the names of components used may be referred to as other names in this art. However, these components may be considered as equivalent components in alternative embodiments if they are functionally similar or identical to each other. Further, the reference numerals of the components are merely given for the convenience of description. However, the components indicated by the reference numerals in the accompanying drawings are not limited by those shown therein. Likewise, if components are functionally similar or identical to each other even though they are partially modified in the drawings according to alternative embodiments, the components may be considered as the equivalent components. Further, when components are recognized as components that should be comprised at the level of those skilled in the art, they are not described. In addition, if it is obvious to those skilled in the art that a component should be comprised, descriptions thereof will be omitted.

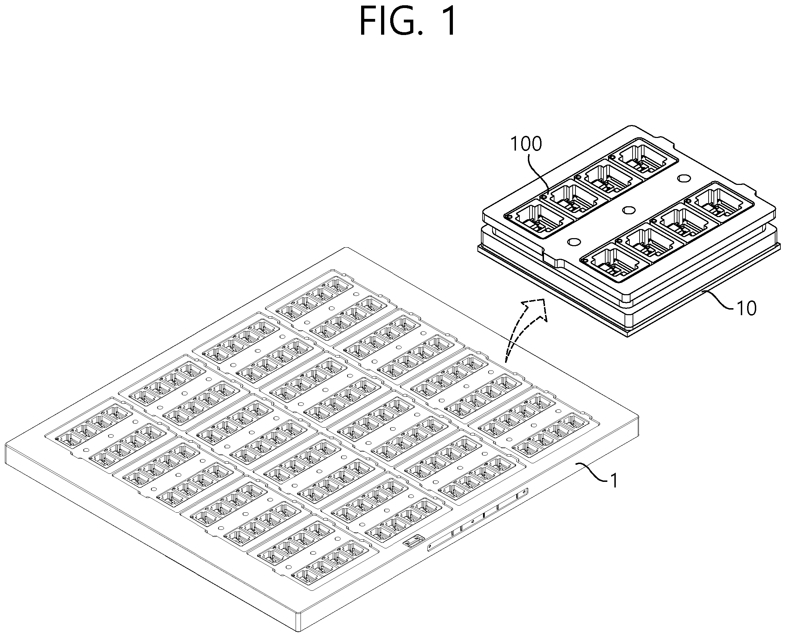

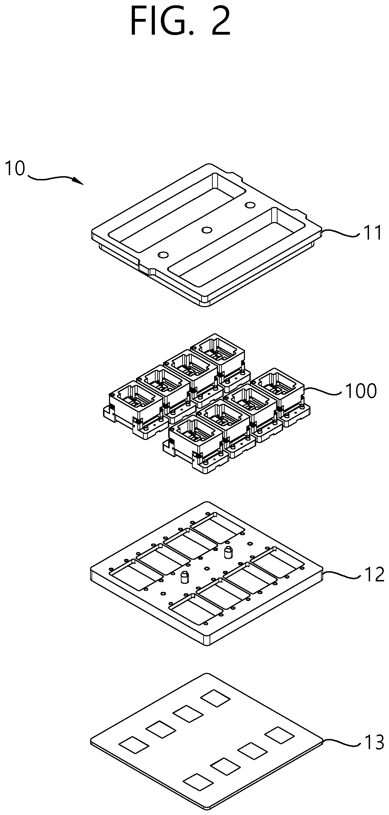

Below, a test tray including an insert module for test hander according to an embodiment of the disclosure will be described with reference to FIGS. 1 and 2.

FIG. 1 is a perspective view of a test tray for an electronic device according to an embodiment of the disclosure, and FIG. 2 is an exploded perspective view of a sub-tray according to an embodiment of the disclosure.

Referring to FIGS. 1 and 2, a test handler for an electronic device according to an embodiment of the disclosure is configured to be transported with a plurality of electronic devices loaded into an insert module 100. Further, the test handler is configured to undergo a test in the state that the electronic devices are loaded into the insert module 100. The test may be performed by equipment called a "handler", which tests the performance of the electronic device under a specific temperature condition and classifies the electronic devices based on their performance.

According to an embodiment of the disclosure, the test tray 1 for the electronic device may comprise the insert module 100, and a board 13.

The insert module 100 may be configured to be arranged on the board 13. The insert module may be coupled to the board at a position given by a frame. The board is provided for electrical connection between the insert module and an external tester head. The board may comprise predetermined circuitry. For example, when the test tray is transported to a test site and operates in connection with a tester, a lower side of the board may be in electrical contact with an interposer of the external tester head.

For example, the insert module may be placed in a plurality of sub-trays 10 provided on the test tray 1. The plurality of sub-trays 10 may be detachably provided in the tray.

In this case, the sub-tray may be detachably provided on an upper side of the board. In other words, as necessary, one or more sub-trays 10 may undergo a test while being coupled to the board. Further, as necessary, the test tray 1 may stay in a separate location, and only the sub-trays 10 may move to a location where the electronic device is loaded or unloaded. The sub-trays 10 may be coupled to the board after being loaded with the electronic device to be tested, or may be separated from the board and transported separately from the board so as to unload the tested electronic device. In this case, a well-known optional fastening element may be used to couple and separate the sub-trays 10 and the board.

The sub-trays 10 may comprise a first base frame 11 and a second base frame 12, which are formed with spaces having a predetermined pattern. The first base frame 11 and the second base frame 12 are coupled in a vertical direction, and configured to couple with a predetermined number of insert modules. The insert modules 100 may be loaded with the electronic devices, respectively. The loaded electronic device may be in electrical contact with the insert modules 100. Each insert module 100 may be electrically connected to the board 13. Ultimately, the electronic devices may be electrically connected to the tester through the insert module 100 and the board 13.

However, the foregoing configuration of the sub-tray may be optionally applied. For example, the sub-tray may be omitted and a first base frame and a second base frame may be changed in shape so that the plurality of insert modules can be in direct contact with the board.

Further, the sub-tray itself may be changed in shape to serve as the test tray.

In this case, the fastening element for coupling and separating the sub-tray 10 and the board may also be omitted. In other words, the test tray may comprise the insert module, the frame, and the board.

The insert module 100 is configured to reliably fix the position of the electronic device while the test tray 1 is being transported or tested. In this case, the contact terminals of the electronic device may be respectively connected to the electrical contact means of the insert module 100 when the electronic device is secured to the insert module 100,

Meanwhile, the contact terminals of the "electronic device" according to the disclosure may be arranged precisely, i.e., at "fine pitch." According to the disclosure, the electronic device may be a memory semiconductor. In particular, the electronic device according to the disclosure may be a high bandwidth memory of which the contact terminals have the fine pitch.

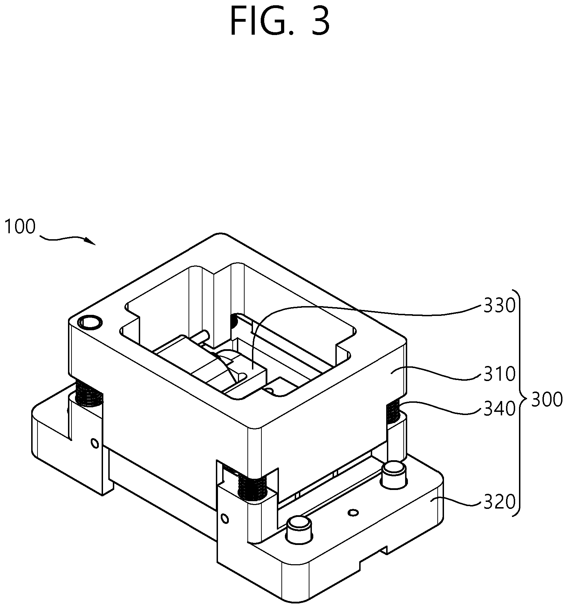

Below, the insert module 100 and its operations according to an alternative embodiment of the disclosure will be described with reference to FIGS. 3 to 8H.

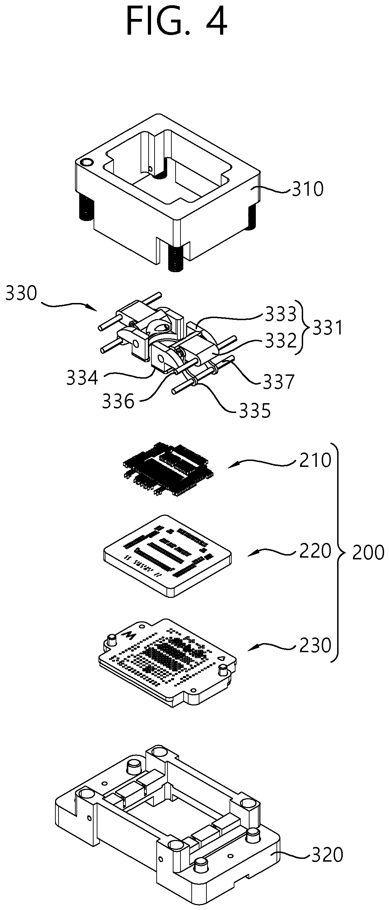

FIG. 3 is a perspective view of an insert module 100 for an electronic device 100 according to an alternative embodiment of the disclosure, and FIG. 4 is an exploded perspective view of the insert module 100 for an electronic device according to the alternative embodiment of the disclosure.

Referring to FIGS. 3 and 4, the insert module 100 for the electronic device according to the alternative embodiment of the disclosure may be configured to load and selectively hold the electronic devices therein.

The finely arranged contact terminals of the electronic device may be an undue burden on alignment when coming into contact with the tester. Further, the handler tests the electronic devices simultaneously for efficient operation. In this case, it takes a lot of time and increases the complexity of the equipment to make multiple electronic devices be precisely aligned and connected to the tester at the same time.

According to the disclosure, the insert module 100 may comprise the contact means of which the pitch is expanded to be larger than that of the contact terminals of the loaded electronic device. According to the disclosure, the insert modules 100 are arranged to be more widely with the electronic devices secured thereto, and comprise the strong contact means, thereby facilitating the connection with the tester.

According to the disclosure, the insert module 100 may comprise a holder 300 and a pitch adjuster 200.

The holder 300 and the pitch adjuster 200 are configured to couple with each other in the vertical direction. The holder 300 and the pitch adjuster 200 may couple with each other to form a socket. The socket may be loaded with one electronic device. The holder 300 may comprise a hole formed at a center portion thereof in the vertical direction, so that the electronic device can be loaded or unloaded through the hole. Further, the pitch adjuster 200 may be placed below the hole.

The holder 300 may comprise an upper block 310, a lower block 320, a latching link 330, and an elastic unit 340. The upper block 310 and the lower block 320 may be coupled to reciprocate a predetermined length in the vertical direction.

The latching link 330 may be configured to have a pivot angle adjusted depending on a distance between the upper block 310 and the lower block 320. The latching link 330 is configured to have bilateral symmetry, and comprises end portions to press the top of the electronic device loaded into the socket.

The latching link 330 may comprise a latching unit 331 and a link 335. The latching unit 331 may comprise a connecting portion 332 and a pushing block 333. The connecting portion 332 is configured to couple with the upper block 310 by a first connection pin 336 on a first side of the latching link 330. The pushing block 333 is configured to press the top of the electronic device on a second side of the latching link 330. The pushing block 333 may comprise a thermal pad 334 to be minimally affected by heat when pushing an upper end portion of the electronic device. In this case, thermal conditions of -100 to 200 degrees Celsius may for example be applied when the electronic device undergoes the test. However, in some cases, the test may be performed under other temperature conditions without being limited to the foregoing temperature range.

The link 335 may have a first side coupled to the lower block 320 by a connection pin. The link 335 may have a second side rotatably coupled to a middle portion of the latching link 330 by a second connection pin 337.

Meanwhile, the operations of the latching link 330 may be geometrically predetermined. According to the disclosure, when the upper block 310 moves down to a position closest to the lower block 320, the pushing block 333 of the latching unit 331 is configured to pivot in an upward direction by 90 or more degrees.

On the other hand, when an external force is removed and the upper block 310 returns to a position farther from the lower block 320, the latching link 330 is adjusted in angle by 90 degrees in a direction opposite to the upward direction and presses the top of the electronic device.

Meanwhile, the pushing block 333 provided in the latching links 330 forming a pair may be formed with recessed structures that face each other in a closed position. The recessed structures of the pushing block 333 is to avoid interference with an PNP device when the socket is closed in the state that the PNP device precisely aligns the electronic device in the socket. The size of the recessed structure may be determined not to come into contact with the PNP device even when the latching unit 331 pivots.

The elastic unit 340 may be configured to provide a restoring force to a latch link. The elastic units 340 are provided between the upper block 310 and the lower block 320 at a plurality of points, and provides the restoring force to the upper block 310 in the upward direction.

The pitch adjuster 200 is configured to expand the electrical contact positions in the state that the electronic device is secured.

The pitch adjuster 200 may comprise a first pin 210, the pitch adjusting block, and a second pin fixing block 230. The pitch expanding block may comprise a conductor 221, and the second pin fixing block 230 may comprise second pins 231. The first pin 210, the conductor 221, and the second pin 231 may be electrically connected. When the second pin 231 is electrically connected to the external tester, the electronic device loaded into the socket may also be electrically connected to the tester. Meanwhile, when the contact terminals of the electronic device are changed in position and arrangement, the first pin 210, the conductor 221, and the second pin 231 of the pitch adjuster 200 may be changed in configuration.

The first pin 210 may be arranged having a contact cross-sectional area suitable for the fine pitch of the electronic device. For example, the first pin 210 may be shaped like a plate. However, this is merely an example, and the first pin 210 may be changed in shape to have various configurations suitable for the fine pitch.

Although the foregoing example shows that the pitch adjuster is provided as a block, the pitch adjuster may be implemented to have a thin structure in which the minimum pitch between the electrical contact means for contact with the tester is allowed to expand. For example, the pitch adjuster may be configured to have a thin structure such as a multilayer circuit, and a glass substrate. The thinness of the pitch adjuster means that it is possible to physically shorten the length of electrical connection between the HBM memory and the tester. When the length of the electrical connection is physically shortened, it is possible to shorten actual response time. This tendency may increase as an operating frequency becomes higher.

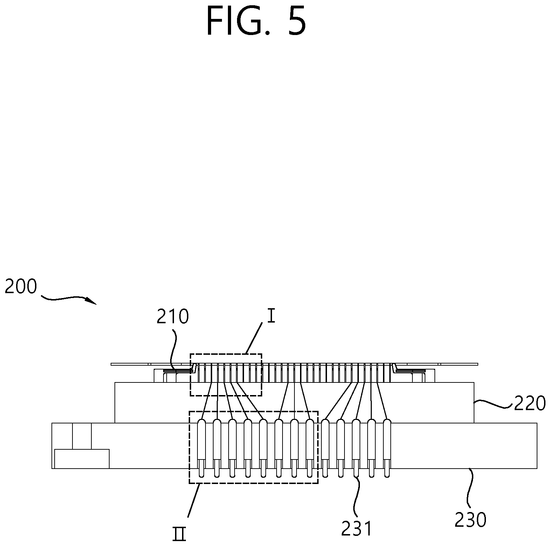

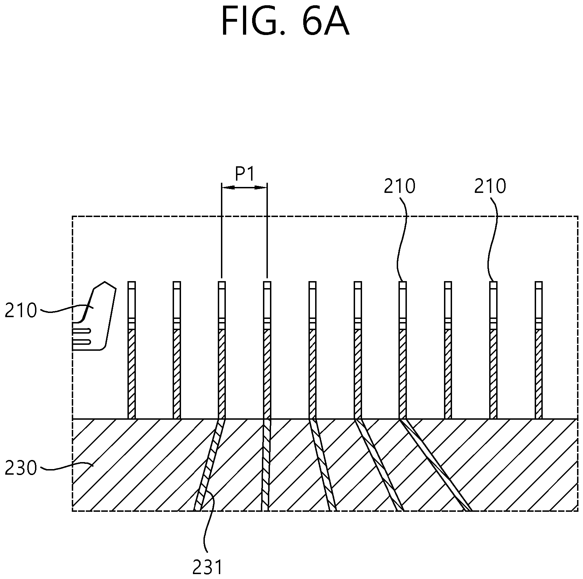

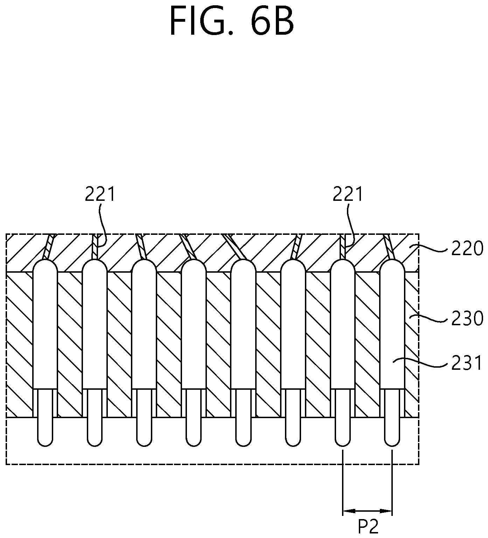

FIG. 5 is a cross-sectional view of the pitch adjuster 200 in the insert module 100 for an electronic device according to the alternative embodiment of the disclosure, FIG. 6A is an enlarged view of 'I' in FIG. 5, and FIG. 6B is an enlarged view of 'II' in FIG. 5.

Referring to FIGS. 5, 6A and 6B, the first pins 210 may be arranged on a plane so as to come into contact with the contact terminals of the electronic device, respectively. In this case, the number of first pins 210 may correspond to the number of contact terminals of the electronic device. Further, the first pins 210 may be arranged in the same manner as the contact terminals arranged in the electronic device. That is, the pitch of the first pins 210 may be the same as the pitch of the electronic device. In other words, the contact terminals of the electronic device and the upper end portions of the first pins may be formed in the same pattern. Although it has been described that the first pins 210 are arranged at a first pitch P1, the description is merely an example. When the contact terminals of the electronic device are connected at various pitches, the first pins 210 may be arranged at various pitches corresponding to the contact terminals.

Meanwhile, according to the disclosure, the first pitch P1 between the first pins 210 may be 0.5 mm or less. In some cases, the first pitch may be 0.2 mm or less. Further, the thickness of the first pin 210 may be 0.2 mm or less. Further, the electrical contact portion of the first pin may have a width of 0.05 mm or less. For example, the first pitch between the first pins may be selected within a range from 0.09 mm to 0.165 mm corresponding to the pitch of a mass-produced HBM die.

A second pin fixing block 230 may comprise the plurality of second pins 231. The plurality of second pins 231 may be arranged at a second pitch P2 wider than the first pitch P1. The second pins 231 are configured to be electrically connected to the electrical contact means of the board. The second pins 231 may be provided penetrating the second pin fixing block 230 in the vertical direction. The second pins 231 may be configured to minimize damage and ensure reliable electrical contact even when repeatedly coming into contact with the external board. Meanwhile, the second pitch P2 may range from 0.3 mm to 3 mm. In this case, the second pin 231 may have a thickness of 0.1 mm to 3 mm.

Meanwhile, the second pitch P2 may expand more than the first pitch P1. For example, the second pitch may expand within 1.1 to 20 times the first pitch.

The second pin 231 may for example be provided as a pogo pin. The pogo pin may be configured with a pair of hollow pins opened at one side and coupled each other in a longitudinal direction. The pogo pin may be internally provided with an elastic body, and decreased in length when pressed in the vertical direction. In other words, the pogo pin is varied in length depending on external force, and maintains the electrical connection even though the length is varied. Therefore, even when the insert module 100 comes into rough contact with the board, the pogo pin minimizes impact and maintain stable contact. Further, the pogo pin is prevented from wearing and the like even though it is used repeatedly, thereby providing the best performance for a long time.

The pitch adjusting block 220 is provided between the first pin 210 and the second pin fixing block 230 and configured to adjust the pitch. The pitch adjusting block 220 may comprise a plurality of conductors 221. At least some of the conductors 221 may be arranged along an inclined path within the pitch adjusting block 220. The conductor 221 may have an upper end exposed to the top of the pitch adjusting block 220, and a lower end exposed to the bottom of the pitch adjusting block 220. The upper ends of the conductors 221 may be in electrical contact with the first pins 210. Further, the lower ends of the conductors 221 may be in electrical contact with the second pins 231 of the second pin fixing block 230.

The conductors 221 may be three-dimensionally arranged within the pitch adjusting block 220. In general, the conductors 221 may be arranged at wider pitch downward within the pitch adjusting block 220.

Meanwhile, although the foregoing embodiment shows an example that the first pins are arranged at the first pitch, the minimum pitch between the adjacent first pins may be the first pitch. Further, the first pins may be arranged at various pitches wider than the first pitch as necessary. In this case, the minimum pitch between the adjacent second pin may be the second pitch, and the second pitch even in this case may be wider than the first pitch.

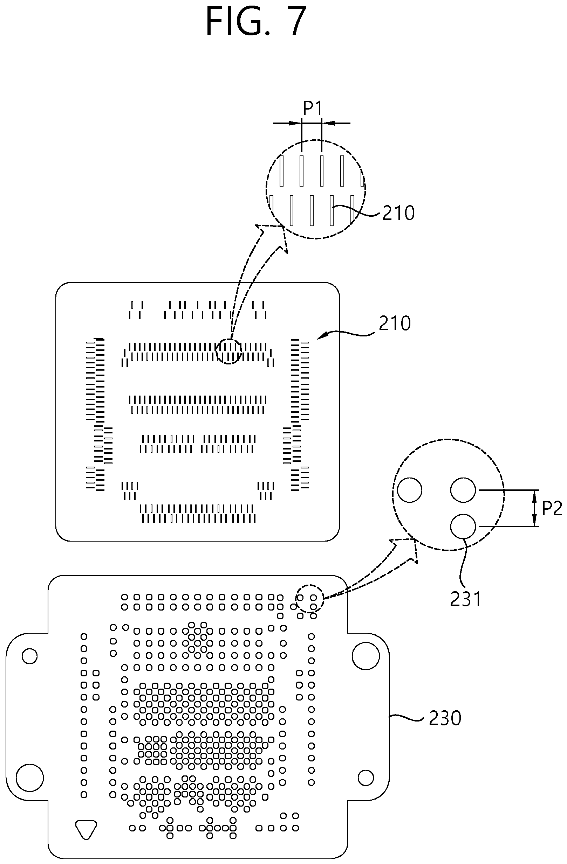

FIG. 7 illustrates the pitch of the first pins 210 and the pitch of the second pins 231 in the insert module 100 for an electronic device according to the alternative embodiment of the disclosure.

Referring to FIG. 7, the second pins 231 may be arranged at a wider pitch than that of the first pins 210. Therefore, high precision for electrical contact is not required after the electronic device is accurately loaded into the insert module 100. This configuration increases a margin of error in alignment of the insert module 100 on the base frame, thereby quickly achieving a coupling process.

According to the disclosure, the insert module 100 holds and transports the electronic device in an unpackaged die state, thereby preventing the electronic device from being damaged while the test tray 1 is transported or when pressed for the test. Further, once the pitch adjuster and the contact terminals of the electronic device are electrically connected in advance, the electrical connection is maintained until unloading. Therefore, there is no need for repeating the connection, thereby preventing the contact terminals of the electronic device from being deformed or damaged.

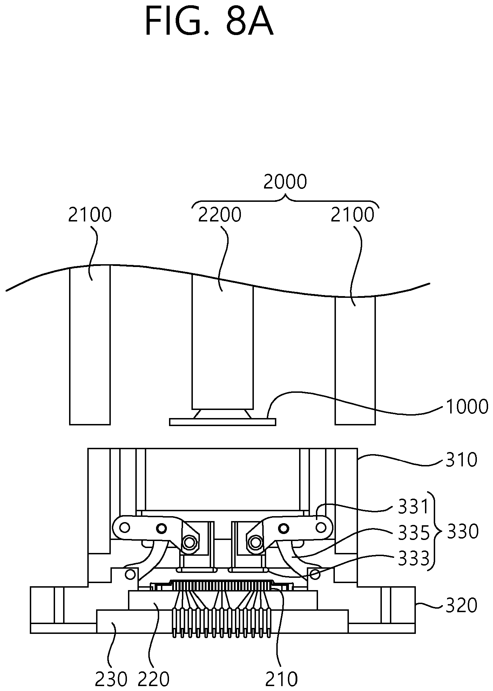

Below, the operations of the insert module 100 for the electronic device and the test tray 1 according to an embodiment of the disclosure will be described with reference to FIGS. 8A to 8H. In Fig. 8a to 8h, for the convenience of description, other components such as the first base frame and the second base frame of the test tray, as well as the tester, are omitted.

For convenience of description, operations of when an electronic device 1000 is loaded into the insert module 100 will be described. However, these operations are merely an example, and may be reversed upon unloading. Further, the cross-section of only one insert module 100 is shown, but this is merely an example. Alternatively, a hand may simultaneously pick up the plurality of electronic devices and simultaneously load them into the insert modules 100. Likewise, the plurality of electronic devices may be unloaded simultaneously.

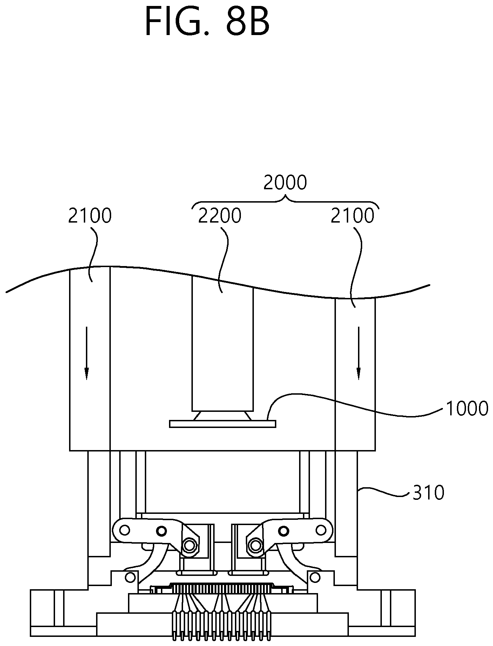

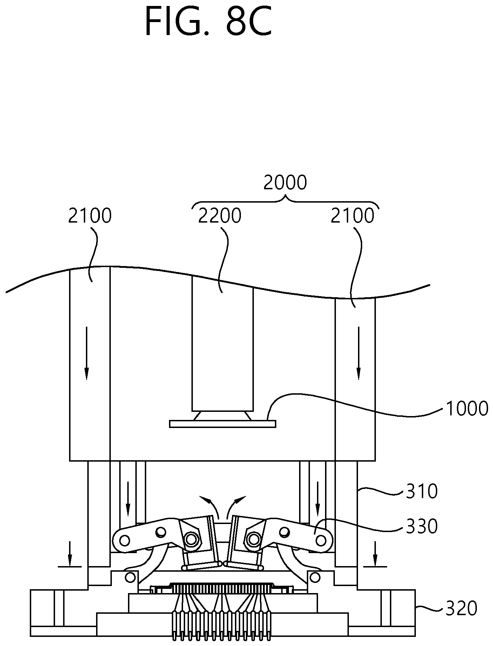

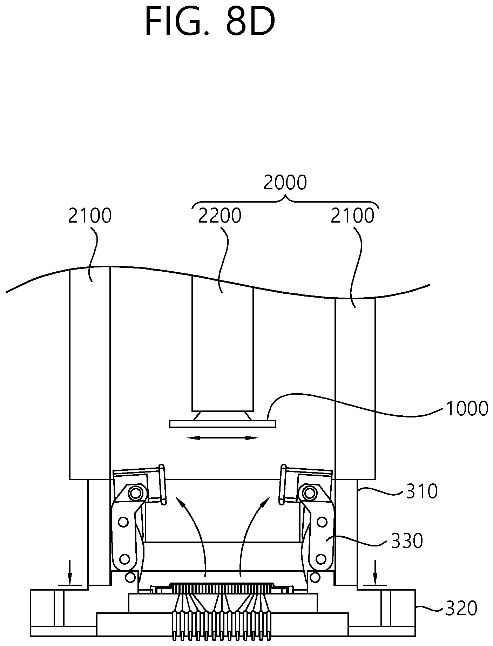

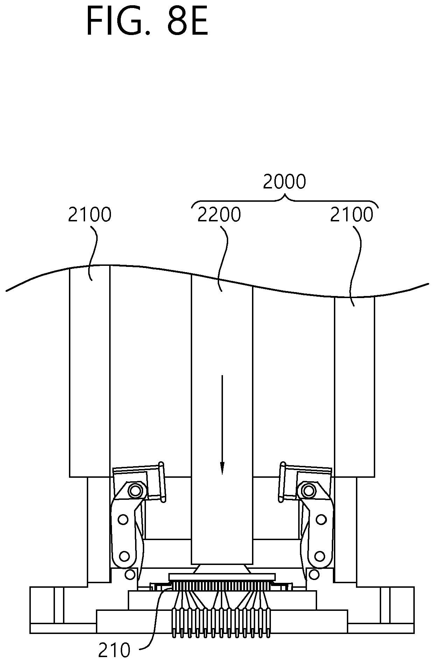

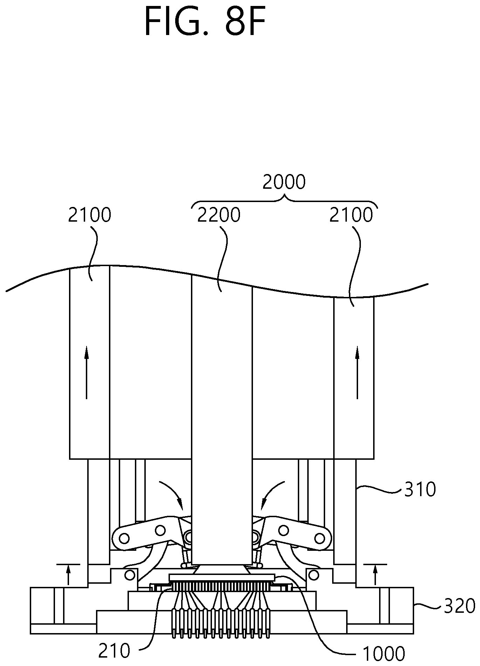

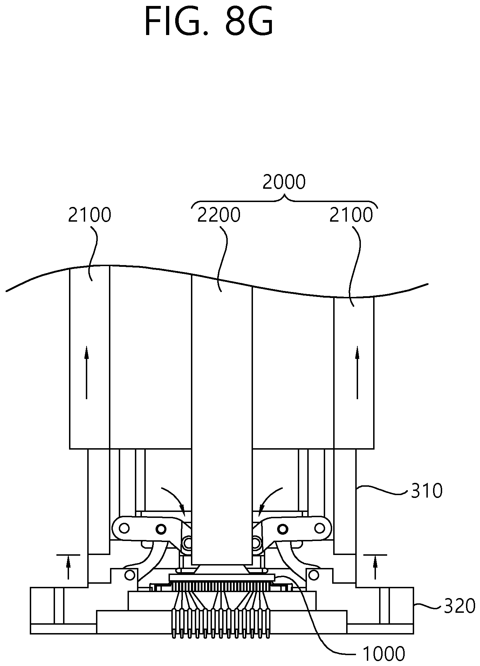

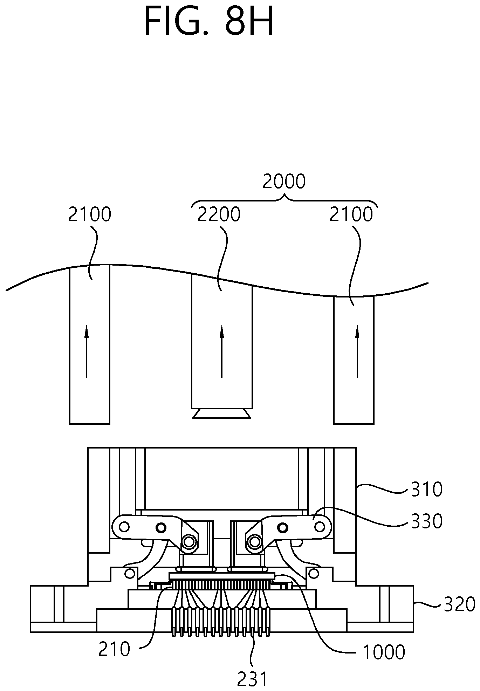

FIGS. 8A, 8B, 8C, 8D, 8E, 8F, 8G and 8H illustrate the use states of the insert module 100 for an electronic device according to an embodiment of the disclosure.

Referring to FIG. 8A, the test tray 1 is transported to a loading position and temporarily fixed. In this case, a picker (or the hand) 2000 picks up the electronic device 1000 from a user tray (not shown) and transport the electronic device to a position above the test tray 1. The picker 2000 may comprise a suction unit 2200 and a picker pusher 2100 for the electronic device 1000. The suction unit 2200 may be configured to move up and down independently of the picker pusher 2100.

Referring to FIG. 8B, the picker pusher 2100 moves down to come into contact with the upper block 310 of an insert module.

Referring to FIG. 8C, the picker pusher 2100 moves down and pushes the upper block 310. In this case, force is transmitted to the latching link 330, and thus the pushing block 333 pivots upward.

Referring to FIG. 8D, the picker pusher 2100 further pushes the upper block 310, and the latching link 330 is completely opened. Meanwhile, the picker 2000 may comprise a vision system. Through the vision system, the picker 2000 can detect a relative position between the socket and the electronic device 1000, and perform precise alignment for the horizontal position of the electronic device 1000.

Referring to FIG. 8E, when the position of the electronic device 1000 is horizontally aligned with the positions of the first pins 210, the suction unit 2200 moves down and places the electronic device 1000 on the top surfaces of the first pins 210.

Referring to FIG. 8F, the position of the suction unit 2200 is fixed in the state that the electronic device 1000 is placed on the top surfaces of the first pins 210, and then the picker pusher 2100 is moved up. As the picker pusher 2100 moves up, the latching link 330 is gradually closed.

Referring to FIG. 8G, when the picker pusher 2100 moves up and is separated from the pushing block 333, the latching link 330 is completely closed pushing the top of the electronic device 1000. In this case, even though the latching links 330 pivot from the open position to the closed position. The latching links 330 do not interfere with the suction unit 2200 due to their recessed structure.

Referring to FIG. 8H, the position of the electronic device 1000 is fixed in the socket by the latching links 330, and the suction unit 2200 and the picker pusher 2100 are moved up, thereby completing the loading operation of the electronic device 1000.

As described above, the electronic devices loaded into the insert module are transported to the tester in the state that their positions are aligned and their connection pins are electrically connected to the test tray. Further, the test tray is electrically connected to the tester while the electrical connection between the electronic device and the test tray is maintained.

When the test tray is electrically connected to the tester, the electrical contact means of the test tray come into electrical contact with the tester, thereby quickly and rapidly achieving the contact without requiring excessive precision.

As described above, the insert module for test tray according to the disclosure and the test tray including the same are capable of the accurate contact corresponding to the fine pitch of the electronic device, and use the pins having the expanded pitch to perform the test. Therefore, damage to the unpackaged electronic device is minimized. Further, the test is quickly performed because additional alignment of the electronic device immediately before the test is not required.

According to the disclosure, the insert module for test tray and the test tray including the same are capable of the accurate contact corresponding to the fine pitch of the electronic device, and maintain the precise contact during the test, thereby improving the accuracy of the test.

Further, the unpackaged die is prevented from damage during the test.

In addition, there is no need for additional alignment of the electronic devices immediately before undergoing the test, and it is thus possible to quickly test and classify the electronic devices.

## Claims

1. An insert module for test hander, comprising:
a pitch adjuster configured to seat at least one electronic device thereon, and comprising a first side electrically connected to connection pins of the electronic device, and a second side provided with electrical contact means at a second pitch wider than a first pitch of the connection pins; and
a holder configured to hold the seated electronic device.

2. The insert module of claim 1, wherein the electronic device comprises a high bandwidth memory.

3. The insert module of claim 2, wherein the pitch adjuster is configured to electrically connect with the connection pins at a plurality of points.

4. The insert module of claim 3, wherein the first pitch is 0.5 mm or less,
wherein the second pitch is 2 to 10 times the first pitch.

5. The insert module of claim 3, wherein the pitch adjuster comprises:
a plurality of first pins arranged at the first pitch; and
a plurality of second pins arranged at the second pitch.

6. The insert module of claim 6, wherein the first pin has a width of 0.2 mm or less,
wherein the second pin has a diameter of 0.3 mm to 3mm.

7. The insert module of claim 5, wherein
the pitch adjuster further comprises a pitch adjusting block provided between the first pin and the second pin, and
the pitch adjusting block comprises a plurality of connectors to electrically connect the first pins and the second pins, respectively.

8. The insert module of claim 7, wherein at least some of the conductors are provided at an angle.

9. The insert module of claim 5, wherein the holder comprises:
an upper block formed with a hole in a center portion thereof to pass the electronic device therethrough; and
a lower block provided with the pitch adjuster in a center portion thereof.

10. The insert module of claim 9, wherein the holder further comprises a latching link having a first side rotatably connected to the upper block and a second side rotatably connected to the lower block.

11. The insert module of claim 10, wherein the latching link is configured to pivot upward upon the upper block moving close to the lower block.

12. The insert module of claim 11, wherein
the latching link further comprises a latching unit, and
wherein one side of the latching unit is rotatably connected to the upper block,
wherein a pushing block configured to press an upper portion of the electronic device is provided on the other side of the latching unit.

13. The insert module of claim 12, further comprising at least one elastic unit provided between the upper block and the lower block, and providing a restoring force to return the upper block to an original position.

14. The insert module of claim 13, wherein the pushing block further comprises a thermal pad provided at an end portion thereof to be in contact with the electronic device.
